# EUROPEAN PATENT APPLICATION

(11) **EP 1 515 366 A2**
(43) Date of publication of application: **16.03.2005**
(21) Application number: 04394053.5
(22) Date of filing: 20.08.2004
(51) Int. Cl.: H01L 23/498, H01L 23/482

(54) **Techniques for pad arrangements on circuit chips**

(30) Priority: 09.09.2003 US 501094 P; 19.05.2004 US 848044
(71) Applicant: Nortel Networks Limited, St. Laurent, Quebec H4S 2A9 (CA)
(72) Inventor: Kwong, Herman, Kanata ON K2L 3S2 (CA); Soh, Kah Ming, Kanata ON K2K 2M2 (US); Marcanti, Larry, Allen TX 75005 (US); Wyrzkowska, Aneta, Dunrobin Ontario K0A 1T0 (CA); Handforth, Martin, Kanata ON K2K 1W2 (CA)
(74) Representative: Coyle, Philip Aidan

(57) **Abstract**

Techniques for improved contact mapping in circuit devices are disclosed. In one particular exemplary embodiment, a technique may be realized as a circuit device comprising a circuit chip having a plurality of electrical contacts positioned at a surface of the circuit chip so as to form one or more channels at the surface, the one or more channels being substantially devoid of electrical contacts such that one or more corresponding channels are formed in a chip carrier for routing electrically conductive traces from one or more of the plurality of electrical contacts on a routing layer of the chip carrier.

## Description

### CROSS-REFERENCE TO RELATED APPLICATIONS

This patent application claims priority to U.S. Provisional Patent Application No. 60/501,094 (Attorney Docket No. 57983.000160, Client Reference No. 16298ROUS01P), filed September 9, 2003, and entitled "Methods and Techniques to Assign Pins to High Density/Speed Chips," which is hereby incorporated by reference herein in its entirety.

This patent application is a continuation-in-part patent application of U.S. Patent Application No. 10/101,211 (Attorney Docket No. 57983.000076, Client Reference No. 14918ROUS01I), filed March 20, 2002, which is a continuation-in-part patent application of U.S. Patent Application No. 09/651,188 (Attorney Docket No. 57983.000010, Client Reference No. 12623ROUS02U), filed August 30, 2000, now U.S. Patent No. 6,388,890, which claims priority to U.S. Provisional Patent Application No. 60/212,387, filed June 19, 2000, all of which are hereby incorporated by reference herein in their entirety.

This patent application is also a continuation-in-part patent application of U.S. Patent Application No. 10/326,123 (Attorney Docket No. 57983.000071, Client Reference No. 14850ROUS01I), filed December 23, 2002, which is a continuation-in-part patent application of the above-referenced U.S. Patent Application No. 10/101,211 (Attorney Docket No. 57983.000076, Client Reference No. 14918ROUS01I), and a continuation-in-part patent application of U.S. Patent Application No. 10/126,700 (Attorney Docket No. 57983.000085, Client Reference No. 12623ROUS03C), filed April 22, 2002, now U.S. Patent No. 6,545,876, which is a continuation of the above-referenced U.S. Patent Application No. 09/651,188 (Attorney Docket No. 57983.000010, Client Reference No. 12623ROUS02U), all of which are hereby incorporated by reference herein in their entirety.

This patent application is also a continuation-in-part patent application of U.S. Patent Application No. 10/326,079 (Attorney Docket No. 57983.000073, Client Reference No. 15057ROUS01I), filed December 23, 2002, which is a continuation-in-part patent application of the above-referenced U.S. Patent Application No. 10/126,700 (Attorney Docket No. 57983.000085, Client Reference No. 12623ROUS03C), and a continuation-in-part patent application of the above-referenced U.S. Patent Application No. 10/101,211 (Attorney Docket No. 57983.000076, Client Reference No. 14918ROUS01I), all of which are hereby incorporated by reference herein in their entirety.

This patent application is also a continuation-in-part patent application of U.S. Patent Application No. 10/407,460 (Attorney Docket No. 57983.000072, Client Reference No. 15041ROUS01I), filed April 7, 2003, which is a continuation-in-part patent application of the above-referenced U.S. Patent Application No. 10/126,700 (Attorney Docket No. 57983.000085, Client Reference No. 12623ROUS03C), a continuation-in-part application of the above-referenced U.S. Patent Application No. 10/101,211 (Attorney Docket No. 57983.000076, Client Reference No. 14918ROUS01I), a continuation-in-part patent application of the above-referenced U.S. Patent Application No. 10/326,123 (Attorney Docket No. 57983.000071, Client Reference No. 14850ROUS01I), and a continuation-in-part patent application of U.S. Patent Application No. 10/326,079 (Attorney Docket No. 57983.000073, Client Reference No. 15057ROUS01I), all of which are hereby incorporated by reference herein in their entirety.

### FIELD OF THE DISCLOSURE

The present disclosure relates generally to circuit devices and, more particularly, to a technique for pin arrangement in a circuit chip.

### BACKGROUND OF THE DISCLOSURE

Circuit devices, such as integrated circuits (ICs), typically are formed starting with a circuit chip, which typically includes circuit components arranged on and connected via a silicon chip substrate or similar dielectric material. The circuit chip further includes a contact pattern comprising electrical contacts positioned at a surface of the chip, where the electrical contacts serve to conduct signals (e.g., input/output or I/O) and power and ground input to and from the circuit chip.

Because the circuit chip typically is relatively fragile and because its contact pattern may not conform to standard contact patterns for interfacing with circuit board substrates or other devices, the circuit chip typically is mated with a chip package to enclose or envelop the circuit chip and to map the contact pattern of the circuit chip to a standard contact pattern (e.g., a contact pattern having a geometry that is typical of those used to interface with circuit board substrates). To achieve this mapping of the contact pattern to a standard contact pattern, the chip package typically includes a plurality of routing layers and vias disposed therein that are used to route conductive traces from the electrical contacts of the contact pattern to their corresponding contacts of the chip package.

While this combination of circuit chip and circuit package often is effective, circuit chip designers frequently design circuit chips in a manner that causes great difficulty for the designer of the corresponding chip package. A main goal of many circuit chip designers is to minimize the surface area, or "footprint," of the circuit chip by achieving the highest density contact pattern possible. However, these high density footprints often result in an excessive number of routing layers in the chip package because the high density of contacts limits the number of electrical traces that may be routed via any given routing layer. Accordingly, this excessive number of routing layers results in an overall circuit device that is overly thick and therefore difficult to integrate into many systems as well as costly to manufacture.

In view of the foregoing, it would be desirable to provide a technique that provides improved contact arrangements in circuit chips.

### SUMMARY OF THE DISCLOSURE

Techniques for improved contact mapping in circuit devices are disclosed. In one particular exemplary embodiment, a technique may be realized as a circuit device comprising a circuit chip having a plurality of electrical contacts positioned at a surface of the circuit chip so as to form one or more channels at the surface of the circuit chip, wherein the one or more channels are substantially devoid of electrical contacts such that one or more corresponding channels are formed in a chip carrier for routing electrically conductive traces from one or more of the plurality of electrical contacts on a routing layer of the chip carrier.

In accordance with other aspects of this particular exemplary embodiment, the circuit device may further beneficially comprise a chip carrier having at least one routing layer for routing electrically conductive traces from one or more of the plurality of electrical contacts toward a periphery of the chip carrier, wherein one or more conductive traces are routed via one or more channels in the at least one routing layer substantially corresponding to one or more of the plurality of channels at the surface of the circuit chip. If such is the case, the one or more channels in the at least one routing layer may beneficially be substantially devoid of vias.

In accordance with further aspects of this particular exemplary embodiment, the plurality of electrical contacts may beneficially include a plurality of signal contacts and a plurality of power and ground contacts, wherein one or more of the plurality of signal contacts may beneficially be positioned at a periphery of the surface of the circuit chip and one or more of the plurality of power and ground contacts may beneficially be positioned at an interior of the surface of the circuit chip. If such is the case, one or more of the plurality of signal contacts may beneficially be positioned adjacent to at least one of the one or more channels.

In accordance with additional aspects of this particular exemplary embodiment, at least one of the one or more channels may beneficially extend from a periphery of the surface of the circuit chip into an interior of the surface of the circuit chip.

In another particular exemplary embodiment, a technique may be realized as a circuit device comprising a circuit chip having a plurality of power and ground electrical contacts and a plurality of signal electrical contacts positioned at a surface of the circuit chip, wherein a substantial portion of the plurality of power and ground electrical contacts are positioned at an interior of the surface of the circuit chip, and wherein a substantial portion of the plurality of signal electrical contacts are positioned at a periphery of the surface of the circuit chip.

In accordance with other aspects of this particular exemplary embodiment, the plurality of power and ground electrical contacts and the plurality of signal electrical contacts may beneficially be positioned so as to form one or more channels at the surface of the circuit chip, wherein the one or more channels may beneficially be substantially devoid of electrical contacts such that one or more corresponding channels are formed in a chip carrier for routing electrically conductive traces from one or more of the plurality of electrical contacts on a routing layer of the chip carrier. If such is the case, the circuit device may further beneficially comprise a chip carrier having at least one routing layer for routing electrically conductive traces from one or more of the electrical contacts toward a periphery of the chip carrier, wherein one or more conductive traces may beneficially be routed via one or more channels in the at least one routing layer substantially corresponding to one or more of the plurality of channels at the surface of the circuit chip. Also, a substantial portion of the plurality of signal electrical contacts may beneficially be positioned adjacent to at least one of the one or more channels.

In yet another particular exemplary embodiment, a technique may be realized as a circuit device comprising a circuit chip having a plurality of electrical contacts positioned at a surface of the circuit chip, wherein a peripheral portion of the surface of the circuit chip has a first density of electrical contacts, wherein an interior portion of the surface of the circuit chip has a second density of electrical contacts, and wherein the second density is substantially less than the first density.

In accordance with other aspects of this particular exemplary embodiment, the circuit chip may further beneficially comprise at least one thermal transfer contact positioned at the interior portion of the surface of the circuit chip.

In accordance with further aspects of this particular exemplary embodiment, the plurality of electrical contacts may beneficially be positioned so as to form one or more channels at the surface of the circuit chip, wherein the one or more channels may beneficially be substantially devoid of electrical contacts such that one or more corresponding channels are formed in a chip carrier for routing electrically conductive traces from one or more of the plurality of electrical contacts on a routing layer of the chip carrier. If such is the case, the circuit device may further beneficially comprise a chip carrier having at least one routing layer for routing electrically conductive traces from one or more of the plurality of electrical contacts toward a periphery of the chip carrier, wherein one or more conductive traces may beneficially be routed via one or more channels in the at least one routing layer substantially corresponding to one or more of the plurality of channels at the surface of the circuit chip.

In still another particular exemplary embodiment, a technique may be realized as a method comprising positioning a plurality of electrical contacts at a surface of a circuit chip so as to form one or more channels at the surface of the circuit chip, wherein the one or more channels are substantially clear of electrical contacts. The method also comprises forming one or more electrically conductive traces at one or more routing layers of a chip carrier supporting the circuit chip, wherein the one or more electrically conductive traces are routed from one or more of the plurality of electrical contacts toward a periphery of the chip carrier via one or more channels in the at least one routing layer substantially corresponding to one or more of the plurality of channels at the surface of the circuit chip.

In accordance with other aspects of this particular exemplary embodiment, the one or more channels in the at least one routing layer of the chip carrier may beneficially be substantially devoid of vias.

In accordance with further aspects of this particular exemplary embodiment, the plurality of electrical contacts may beneficially include a plurality of signal contacts and a plurality of power and ground contacts, wherein one or more of the plurality of signal contacts may beneficially be positioned at a periphery of the surface of the circuit chip and one or more of the plurality of power and ground contacts may beneficially be positioned at an interior of the surface of the circuit chip. If such is the case, one or more of the plurality of signal contacts may beneficially be positioned adjacent to at least one of the one or more channels.

The present disclosure will now be described in more detail with reference to exemplary embodiments thereof as shown in the appended drawings. While the present disclosure is described below with reference to preferred embodiments, it should be understood that the present disclosure is not limited thereto. Those of ordinary skill in the art having access to the teachings herein will recognize additional implementations, modifications, and embodiments, as well as other fields of use, which are within the scope of the present disclosure as described herein, and with respect to which the present disclosure may be of significant utility.

### BRIEF DESCRIPTION OF THE DRAWINGS

In order to facilitate a fuller understanding of the present disclosure, reference is now made to the appended drawings. These drawings should not be construed as limiting the present disclosure, but are intended to be exemplary only.
Figure 1 is a view of a surface of a circuit chip having an exemplary electrical contact pattern having at least one channel in accordance with at least one embodiment of the present disclosure.
Figures 1B and 1C are views of an exemplary first routing layer and second routing layer, respectively, of a circuit package corresponding to the circuit chip of Figure 1A in accordance with at least one embodiment of the present disclosure.
Figure 1D is an overlay view of various layers of a circuit device formed from the circuit chip of Figure 1A and the circuit package of Figures 1B and 1C in accordance with at least one embodiment of the present disclosure.
Figure 1E illustrates an expanded view of a circuit device formed from the circuit chip of Figure 1A and the circuit package of Figures 1B and 1C in accordance with at least one embodiment of the present disclosure.
Figures 2-10 are views of exemplary circuit chips having electrical contacts positioned so as to form various channel patterns in accordance with at least one embodiment of the present disclosure.
Figure 11A is a view of an exemplary circuit chip having electrical contacts positioned so as to locate high-speed signal contacts at a periphery of the circuit chip.
Figure 11B is an overlay view of various layers of the exemplary circuit chip of Figure 11A and two routing layers of a corresponding circuit package in accordance with at least one embodiment of the present disclosure.
Figures 12A-12C are views of various layers of an exemplary circuit device having a circuit chip with a higher density of electrical contacts at its periphery than at its interior in accordance with at least one embodiment of the present disclosure.

### DETAILED DESCRIPTION OF EXEMPLARY EMBODIMENT(S)

At the outset, it is helpful to refer to the microvia-based techniques for reducing the number of layers in a multilayer signal routing device and the power/ground-based techniques for reducing the number of layers in a multilayer signal routing device as have been substantially described in the above-referenced U.S. Provisional Patent Application No. 60/501,094, the above-referenced U.S. Patent Application No. 09/651,188 (Attorney Docket No. 57983.000010, Client Reference No. 12623ROUS02U), now U.S. Patent No. 6,388,890, the above-referenced U.S. Patent Application No. 10/101,211 (Attorney Docket No. 57983.000076, Client Reference No. 14918ROUS01I), the above-referenced U.S. Patent Application No. 10/126,700 (Attorney Docket No. 57983.000085, Client Reference No. 12623ROUS03C), now U.S. Patent No. 6,545,876, the above-referenced U.S. Patent Application No. 10/326,123 (Attorney Docket No. 57983.000071, Client Reference No. 14850ROUS01I), the above-referenced U.S. Patent Application No. 10/326,079 (Attorney Docket No. 57983.000073, Client Reference No. 15057ROUS01I), and the above-referenced U.S. Patent Application No. 10/407,460 (Attorney Docket No. 57983.000072, Client Reference No. 15041ROUS01I), all of which have been incorporated by reference herein in their entirety. The above-referenced techniques may be used beneficially in conjunction with one or more of the techniques described herein. It should be noted, however, that the techniques described herein may also be used separately to effectively arrange the contacts of a circuit chip in a circuit device.

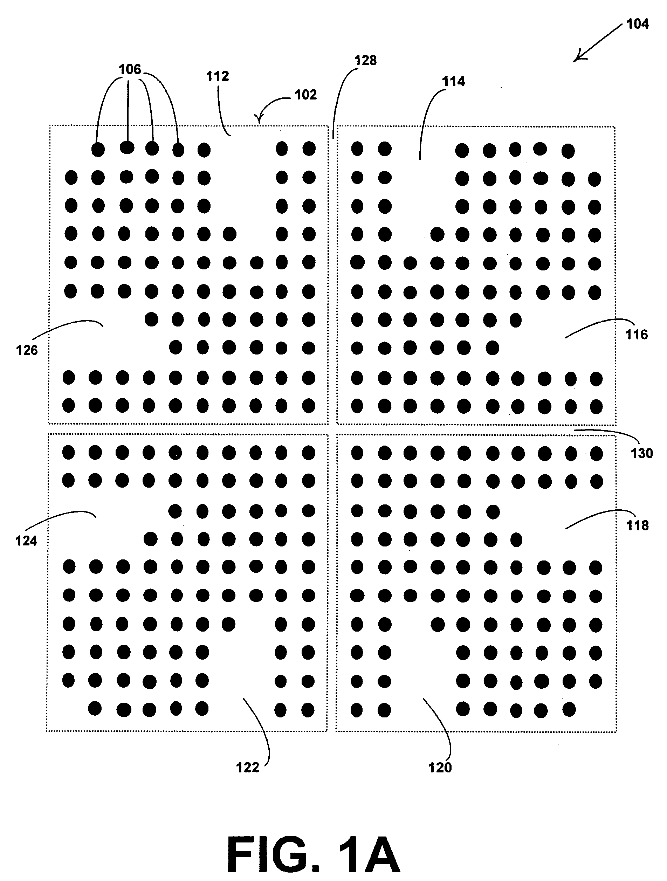

Referring now to Figures 1A-1C, an exemplary technique for arranging the electrical contacts of a circuit chip to provide for improved conductive trace routing in the corresponding circuit package is illustrated in accordance with at least one embodiment of the present disclosure.

Figure 1A illustrates an overhead view of a surface 102 of a circuit chip 104 having a plurality of electrical contacts (e.g., electrical contacts 106) positioned at the surface 102. As noted above, the electrical contacts may be used to conduct signals to and from one or more circuit components (not shown) utilized in the circuit chip 104, as well as to provide power and ground connections to the circuit components. The electrical contacts may take many different forms. For example, in one case, such as in flip chip technology, the electrical contacts may be electrically conductive pads having high temperature solder balls (e.g., 0.005 inch in diameter with 95% lead and 5% tin) soldered thereto. These solder balls may then be soldered to corresponding electrical contacts of an underlying circuit package (not shown). In another case, the electrical contacts may be formed as electrically conductive dendrites, bumps, or studs, which may then be soldered to corresponding electrical contacts of an underlying circuit package (not shown).

In at least one embodiment, the electrical contacts are positioned or arranged at the surface 102 of the circuit chip 104 so as to form one or more channels substantially absent of electrical contacts. In the illustrated example, the electrical contacts are positioned to form channels 112-130, where the channels 112-126 extend from the periphery of the surface 102 toward the interior of the surface 102 and channels 128 and 130 traverse the surface 102. These channels then may be used to optimize the break out pattern of electrically conductive traces in the corresponding circuit package by routing one or more of the conductive traces from the periphery of the surface 102 to the corresponding electrical contact at least partially via one or more of the channels.

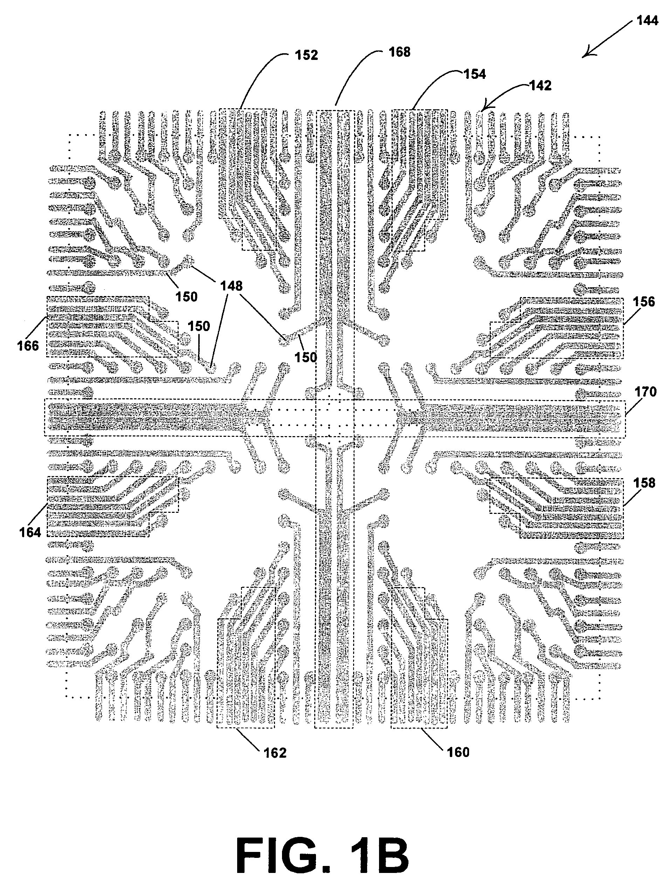

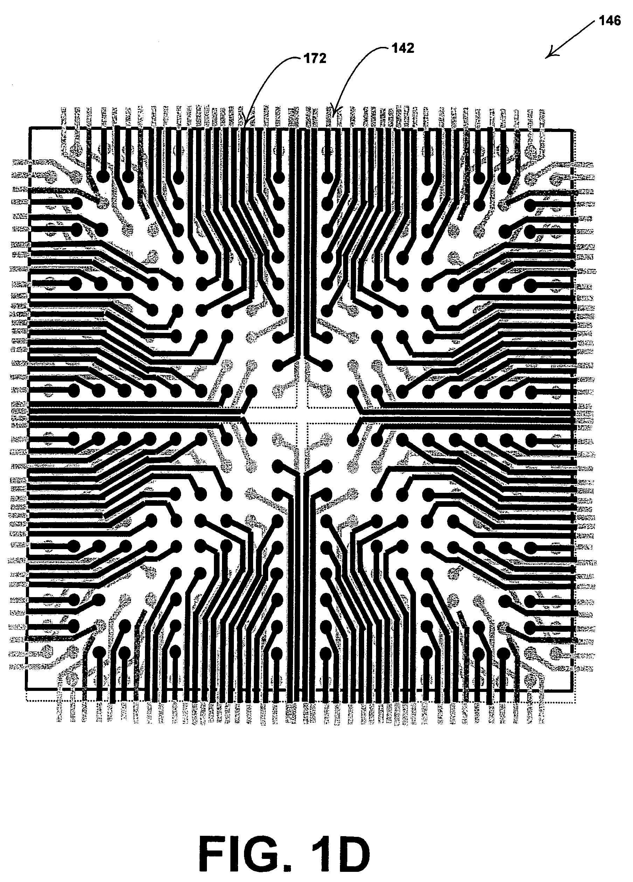

To illustrate, Figure 1B depicts a top view of an exemplary first routing layer 142 of a circuit package 144 (which may be combined with the circuit chip 104 to form a circuit device 146 as illustrated with reference to Figure 1D). The routing layer 142 preferably is positioned substantially parallel to the surface 102 and is substantially coextensive with the surface 102. The first routing layer 142 may be in direct contact with the surface 102 of the circuit chip 104 or one or more dielectric or conductive layers may be disposed between the surface 102 and the first routing layer 142.

In the illustrated embodiment, the first routing layer 142 may be a top layer of the circuit package 144 or the first routing layer 142 may be an internal layer of the circuit package 144. If the first routing layer 142 is a top layer of the circuit package 144, electrically conductive pads (e.g., pads 148) may be formed at the first routing layer 142 for electrically interconnecting a first subset of the electrical contacts of the circuit chip 104 to the circuit package 144. To provide a conductive path between the electrically conductive pads and the periphery of the circuit package 144, electrically conductive traces (e.g., conductive traces 150) may be formed between the periphery and the respective pads.

Alternatively, if the first routing layer 142 is an internal layer of the circuit package 144, electrically conductive vias (e.g., vias 148) may be formed between the first routing layer 142 and a top layer of the circuit package 144 for electrically interconnecting a first subset of the electrical contacts of the circuit chip 104 and the routing layer 142. To provide a conductive path between the electrically conductive vias and the periphery of the circuit package 144, electrically conductive traces (e.g., conductive traces 150) may be formed between the periphery and the respective vias. The electrically conductive vias may include, for example, microvias, through holes, and the like.

Because the channels 112-130 of the circuit chip 104 are substantially devoid of any electrical contacts, it will be appreciated that channels 152-170 corresponding to channels 112-130 thus may be created in the first routing layer 142 as few or no vias are present in these channels 152-170 as no electrical contacts are positioned in the corresponding section of the contact pattern at the surface 102. Accordingly, these channels may be used to facilitate the routing of the electrically conductive traces by routing at least a portion of each of one or more of the electrically conductive traces through one or more of the channels 152-170. The connection of a subset of the electrical contacts of the circuit chip 104 to a routing layer of the circuit package 144 may be repeated for one or more routing layers of the circuit package 144.

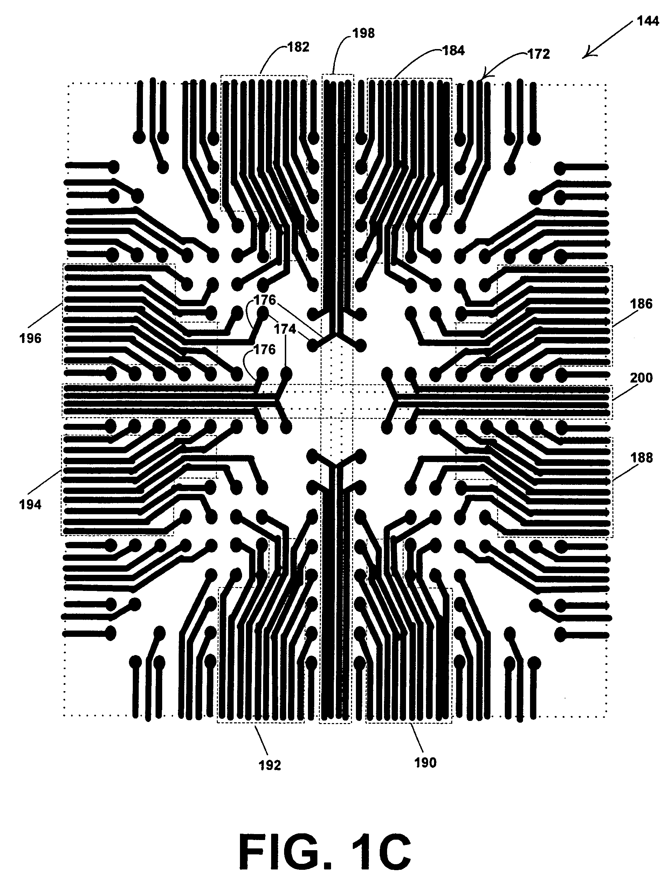

To illustrate, Figure 1C depicts a top view of an exemplary second routing layer 172 of the circuit package 144. The first routing layer 142 is positioned between the second routing layer 172 and the surface 102 and as with the first routing layer 142, the second routing layer 172 preferably is positioned substantially parallel to the surface 102 and is substantially coextensive with the surface 102.

In the illustrated embodiment, vias (e.g., vias 174) may be formed at the second routing layer 172 to create electrically conductive paths between a second subset of the electrical contacts of the circuit chip 104 and the second routing layer 172. As with the first routing layer 142, electrically conductive traces (e.g., conductive traces 176) may be formed between the periphery and the respective vias of the second routing layer 172 to provide conductive paths between these vias and the periphery of the circuit package 144 (and thus conductive paths between the corresponding electrical contacts and the periphery of the circuit package 144). Moreover, as with the channels 152-170 of the first routing layer 142, channels 182-190 may be present in the second routing layer 172 as no electrical contact is situated in the corresponding section of the contact pattern at the surface 102. Accordingly, the channels 182-200 may be used to facilitate the routing of the electrically conductive traces by routing at least a portion of each of one or more of the electrically conductive traces through one or more of the channels 182-200. This process may be repeated for a third routing layer, a fourth routing layer, and so on.

Figure 1D illustrates an overlay view of the first routing layer 142 and the second routing layer 172. As may be realized from Figure 1D, the channels formed in the routing layers 142 and 172 resulting from the arrangement of the electrical contacts of the circuit chip 104 may be advantageously used to arrange vias and route conductive traces for the electrical contacts without overcrowding a particular routing layer or requiring an excessive number of routing layers. To illustrate, without the use of the channels at the routing layers 142 and 172, fewer electrical contacts could be broken out for any given routing layer, resulting in the need for more than two routing layers to break out all of the electrical contacts of the circuit chip 104.

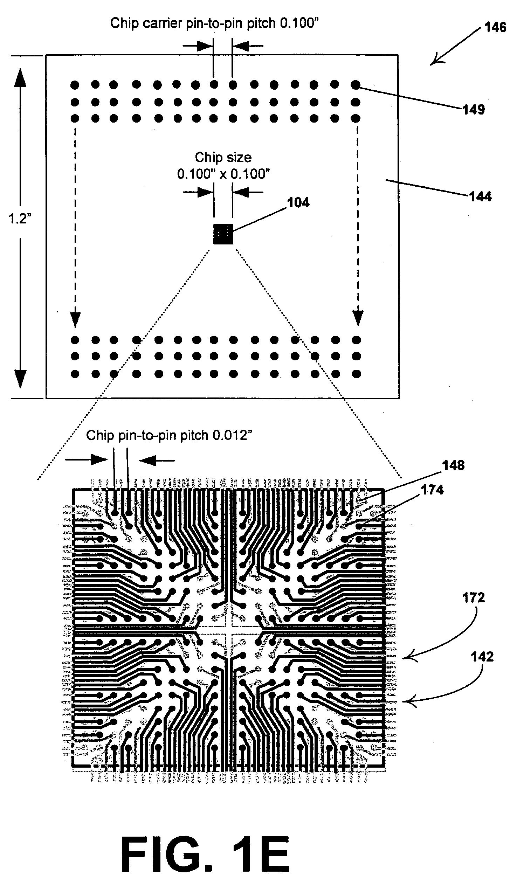

Figure 1E illustrates an expanded view of the circuit device 146 formed from the circuit chip 104 of Figure 1A and the circuit package 144 of Figures 1B and 1C in accordance with an embodiment of the present disclosure. Specifically, Figure 1E shows the pitch of circuit package contacts (e.g., contacts 149) to be 0.100 inches for an exemplary embodiment. Figure 1E also shows the pitch of the circuit chip contacts/vias (e.g., contacts/vias 148 and 174) to be 0.012 inches for an exemplary embodiment. Figure 1E further shows the size of the circuit chip 104 to be 0.100 x 0.100 square inches for an exemplary embodiment.

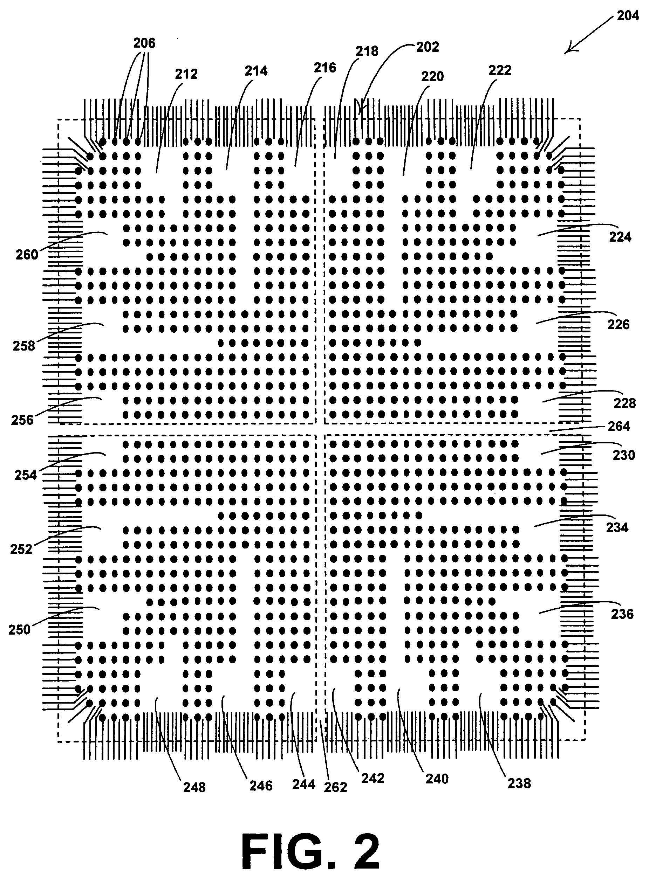

Referring now to Figures 2-10, additional exemplary electrical contact arrangements that form one or more channels on a circuit chip that are substantially devoid of electrical contacts are illustrated in accordance with at least one embodiment of the present disclosure. Although various exemplary electrical contact arrangements are depicted for illustrative purposes, those skilled in the art may utilize other contact arrangements using the guidelines provided herein without departing from the spirit or the scope of the present disclosure.

Figure 2 illustrates an overhead view of a surface 202 of a circuit chip 204 having a plurality of electrical contacts (e.g., contacts 206) arranged so as to form channels 212-264 at the surface 202. As with the circuit chip 104 (Figures 1A-1D), the electrical contacts may be arranged so as to form channels 212-260 that extend partially from the periphery of the surface 202 to an interior of the surface 202 whereas channels 262 and 264 traverse the surface 202. The formation of the channels 212-260 result in a "snowflake" pattern that has the benefit of causing a reduced density of electrical contacts at the peripheral sections of the surface 202, thereby facilitating a more orderly routing of electrically conductive traces at the one or more routing layers of a corresponding circuit package (not shown). Of course, other random patterns that are symmetric or non-symmetric about the center of the surface 202 of the circuit chip 204 may be utilized in accordance with the present disclosure.

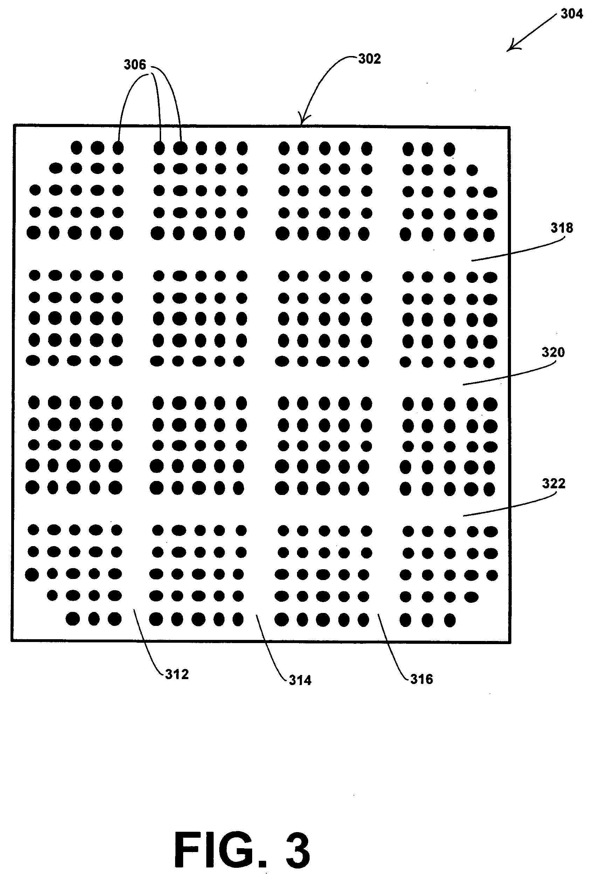

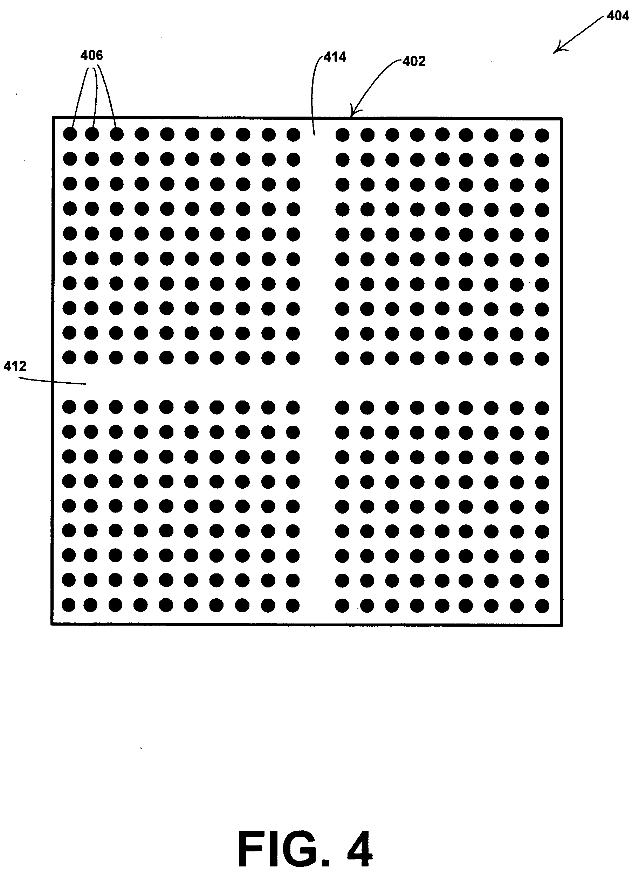

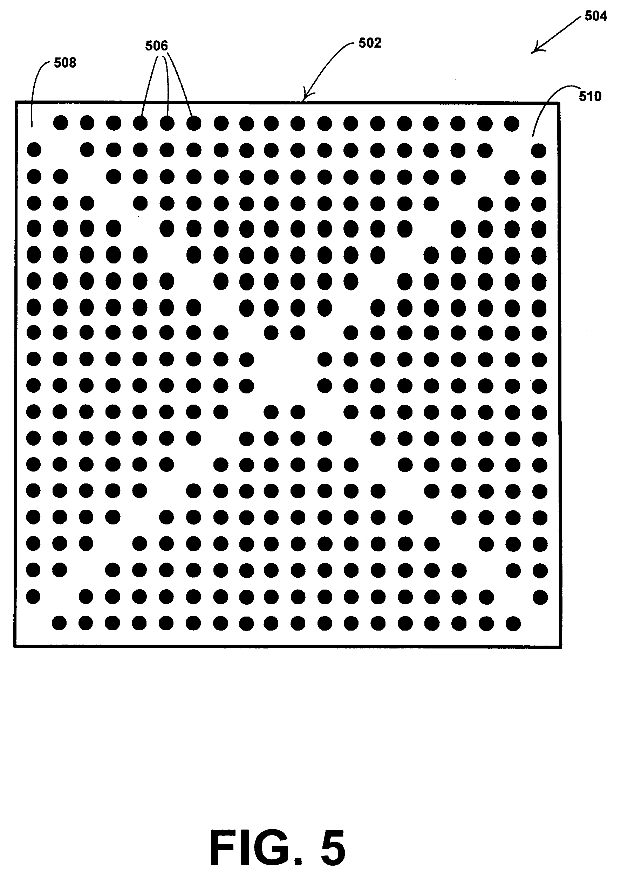

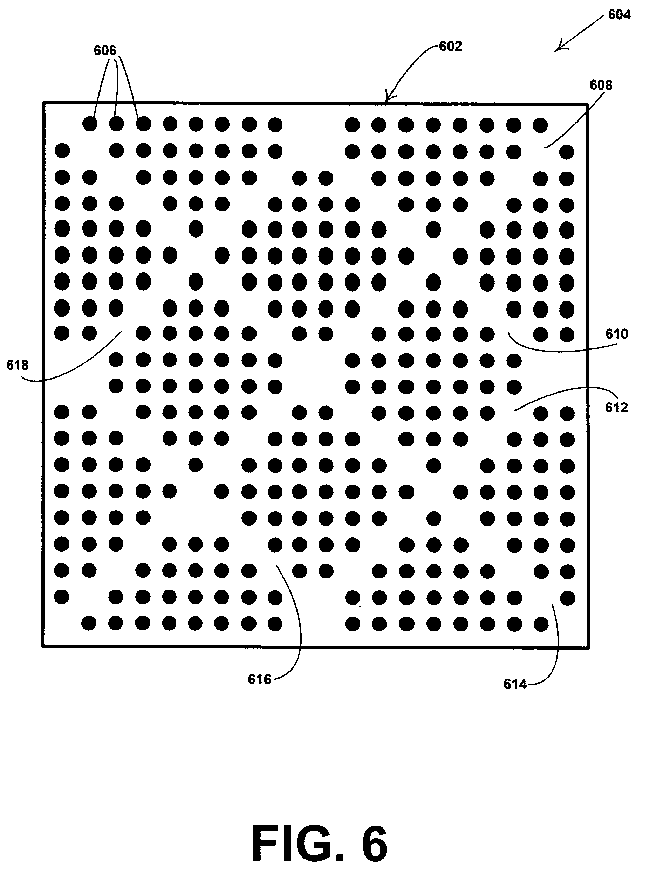

Figure 3 illustrates an overhead view of a surface 302 of an exemplary circuit chip 304 having electrical contacts (e.g., electrical contacts 306) arranged at the surface 302 so as to form channels 312-322 which traverse the surface 302, resulting in the segmentation of the electrical contacts into sixteen grid sections. Figure 4 illustrates an overhead view of a surface 402 of a circuit chip 404 having electrical contacts (e.g., contacts 406) arranged at the surface 402 so as to form channels 412 and 414 which traverse the surface 402 and segment the contacts into four grid sections. Figure 5 illustrates an overhead view of a surface 502 of a circuit chip 504 having electrical contacts (e.g., contacts 506) arranged at the surface 502 so as to form channels 508 and 510 extend diagonally across the surface 502 that segment the surface 502 into four roughly triangular sections. Figure 6 illustrates an overhead view of a surface 602 of a circuit chip 604 having electrical contacts (e.g., contacts 606) arranged at the surface 602 so as to form diagonal channels 608-618 that segment the surface 602 into twelve roughly triangular or diamond-shaped sections.

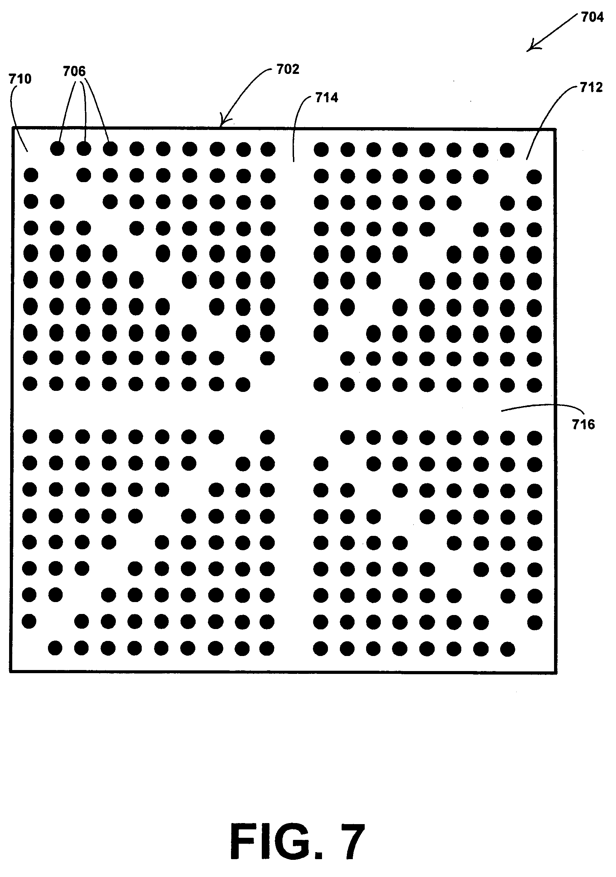

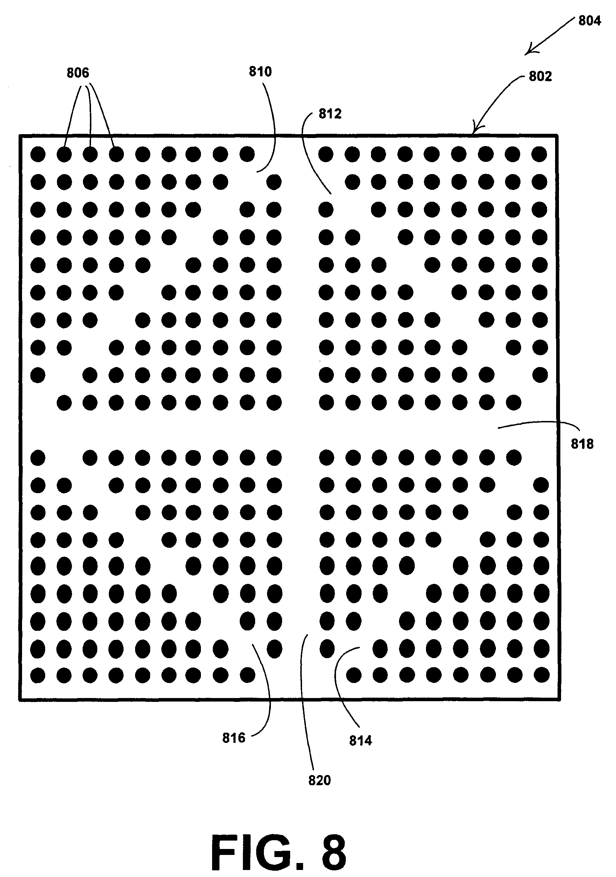

In addition to implementing a particular channel shape (e.g., a traverse or diagonal channel), in at least one embodiment, two or more channel shapes may be implemented. To illustrate, Figure 7 depicts an overhead view of a surface 702 of a circuit chip 704 having electrical contacts (e.g., contacts 706) arranged at the surface 702 so as to form diagonal channels 710 and 712 and traverse channels 714 and 716 and Figure 8 depicts an overhead view of a surface 802 of a circuit chip 804 having electrical contacts (e.g., contacts 806) arranged at the surface 802 so as to form diagonal channels 810-816 and traverse channels 818 and 820.

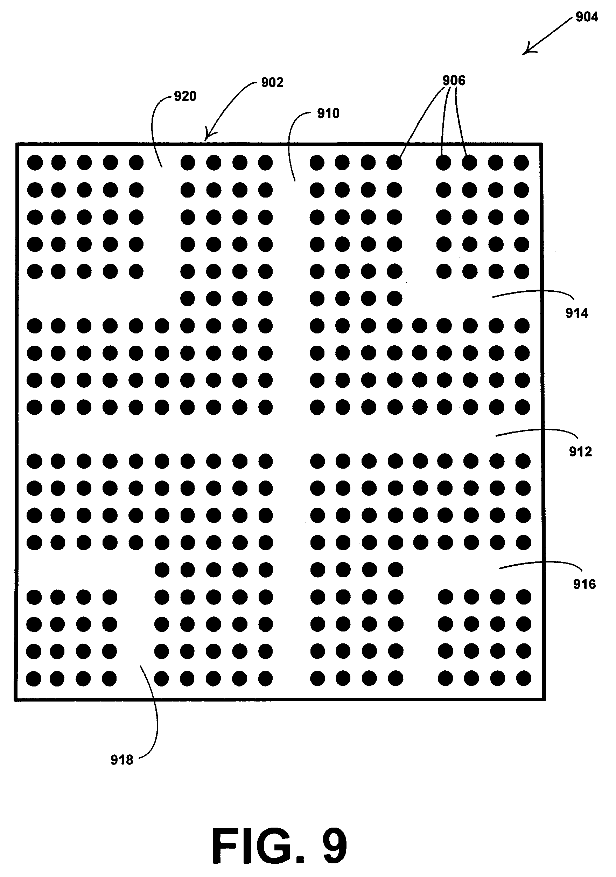

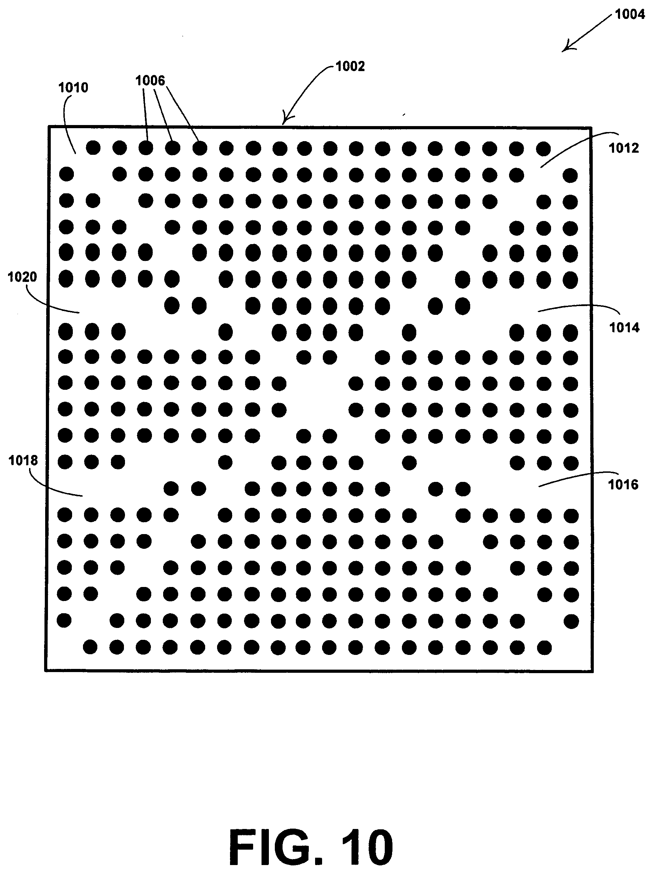

Similarly, electrical contacts of a circuit chip may be positioned so as to form channels having varying routes across the surface of the circuit chip. To illustrate, Figure 9 depicts an overhead view of a surface 902 of a circuit chip 904 having electrical contacts (e.g., contacts 906) arranged at the surface 902 so as to form traverse channels 910 and 912 and traverse channels 714 and 716 and "L" shaped channels 914-920 at the corners of the surface 902. Similarly, Figure 10 depicts an overhead view of a surface 1002 of a circuit chip 1004 having electrical contacts (e.g., contacts 1006) arranged at the surface 1002 so as to form diagonal channels 1010 and 1012 and stepped channels 1014-1020.

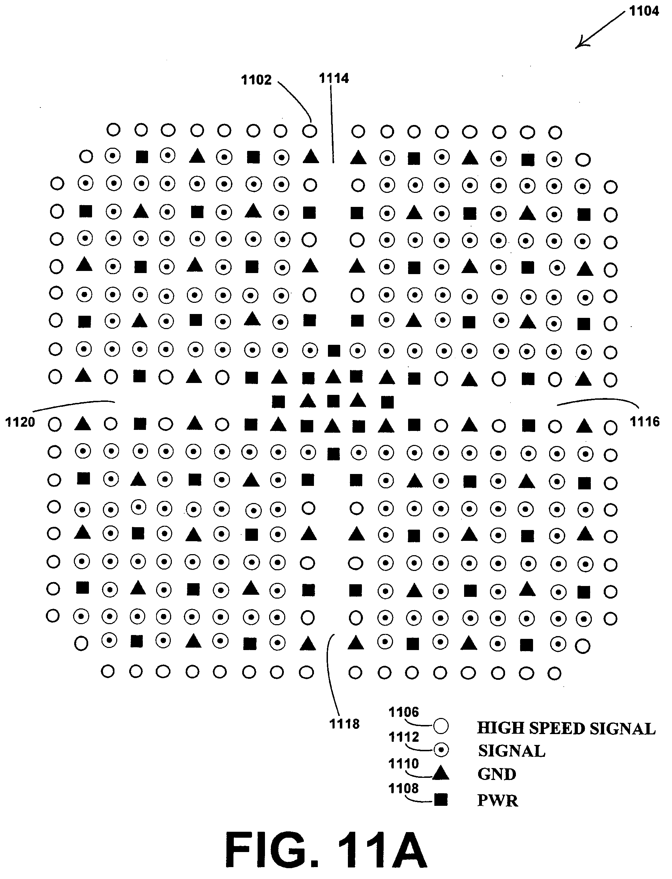

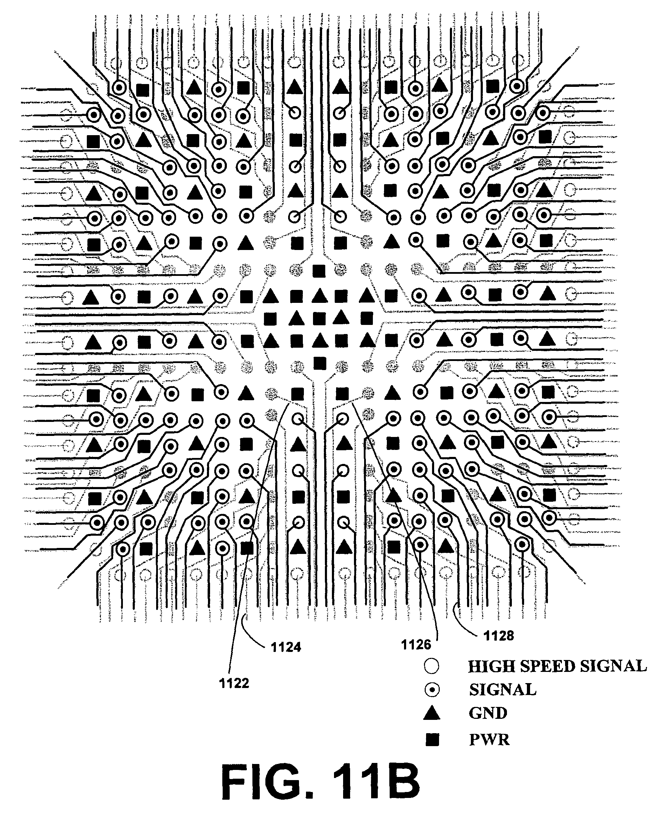

Referring now to Figures 11A and 11B, an exemplary technique for improving circuit chip contact breakout is illustrated in accordance with at least one embodiment of the present disclosure. Figure 11A illustrates an overhead view of a surface 1102 of a circuit chip 1104 having a plurality of electrical contacts positioned at the surface 1102. As noted above, these contacts may be used to conduct signals to and from one or more circuit components (not shown) utilized in the circuit chip 1104 or to provide power and ground connections to the circuit components.

In at least one embodiment, the electrical contacts are positioned or arranged at the surface 1102 of the circuit chip 1104 so as to form one or more channels substantially absent of electrical contacts. In the illustrated example, the electrical contacts are positioned to form channels 1114-1120, where the channels 1114-1120 extend from the periphery of the surface 1102 toward the interior of the surface 1102, where channels may be used to optimize the break out pattern of electrically conductive traces in the corresponding circuit package by routing one or more of the conductive traces from the periphery of the surface 1102 to the corresponding electrical contacts at least partially via one or more of the channels.

Additionally, in at least one embodiment, those electrical contacts that are used to carry high-speed signals (e.g., contacts 1106) may be positioned at or near the periphery of surface 1102 or at or near the sides of the channels 1114-1120, while less critical contacts, such as power contact (e.g., contacts 1108) or ground contacts (e.g., contacts 1110) or low-speed signals (e.g., contacts 1112), may be positioned toward the interior of the surface 1102 or away from the sides of the channels 1114-1120.

Figure 11B illustrates an overlay view of the surface 1102 of the circuit chip 1104 and at least first and second routing layers of a chip package corresponding to the circuit chip 1104. The lighter-shaded conductive traces (e.g., traces 1122 and 1124) represent conductive traces at the first routing layer adjacent to the surface 1102 and the darker-shaded conductive traces (e.g., traces 1126 and 1128) represent conductive traces at the second routine layer.

As may be realized from Figure 11B, the channels formed in the routing layers 142 and 172 as a result of, or corresponding to, the arrangement of the electrical contacts of the circuit chip 1104 may be advantageously used to arrange vias and route conductive traces for the electrical contacts without overcrowding a particular routing layer or requiring an excessive number of routing layers. Moreover, it will be appreciated that the placement of those contacts which carry high-speed signals at or near the periphery of the surface or at or near the side of a channel enables the use of shorter conductive traces to breakout the contacts of the circuit chip 1104 to the exterior of the corresponding chip package, thereby reducing the transmission delays of the high-speed signals over the corresponding conductive traces.

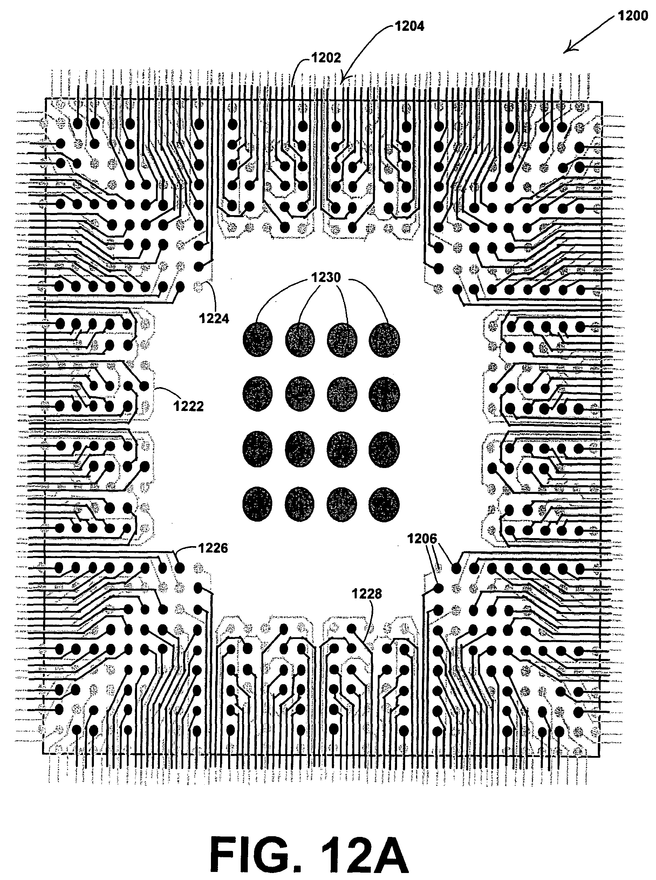

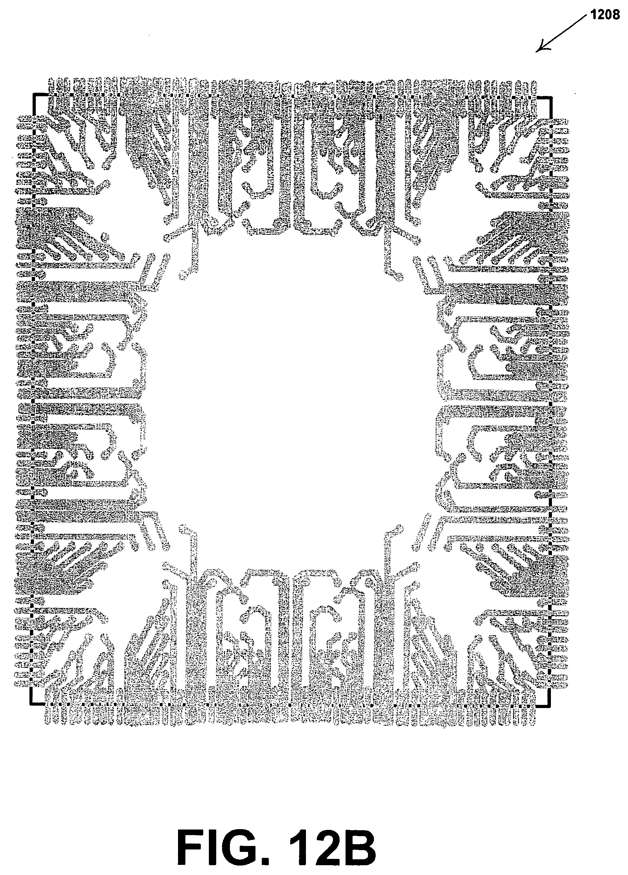

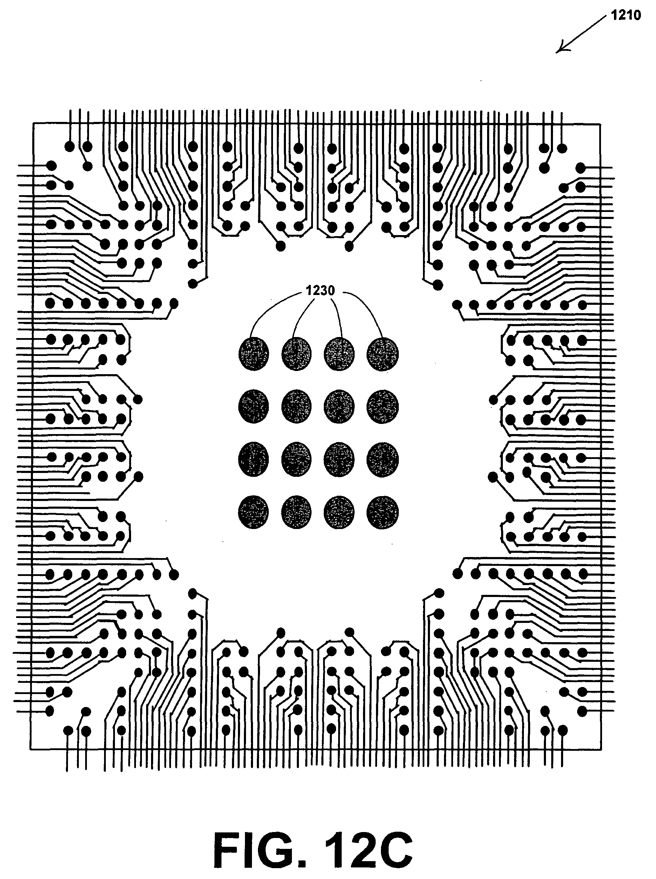

Referring now to Figures 12A-12C, another exemplary technique for improving circuit chip contact breakout is illustrated in accordance with at least one embodiment of the present disclosure. Figure 12A illustrates an overlay view of a surface of a circuit chip 1204 and at least first routing layer 1208 and second routing layer 1210 of a chip package corresponding to the circuit chip 1204 combined to form a circuit device 1200. The lighter-shaded conductive traces (e.g., traces 1222 and 1224) represent conductive traces at the first routing layer 1208 adjacent to the surface of the circuit chip 1204 and the darker-shaded conductive traces (e.g., traces 1226 and 1228) represent conductive traces at the second routine layer 1210. Figures 12B and 12C illustrate an overhead view of only the first routing layer 1206 and the second routing layer 1208, respectively, for purposes of clarity.

As Figures 12A-12C illustrate, in at least one embodiment, the electrical contacts (e.g., contacts 1206) are positioned at the surface of the circuit chip 1202 such that the peripheral portion of the surface of the circuit chip has a higher density of electrical contacts than the interior portion, where the inner portion preferably is substantially devoid of electrical contacts. In at least one embodiment, the different densities of electrical contacts may be accomplished by utilizing a larger die for the circuit chip than conventionally would be used for the same number of electrical contacts and positioning the electrical contacts toward the periphery of the larger-size die. As a result, the electrical contacts may be more spaciously distributed, thereby allowing for a more effective conductive trace routing pattern to breakout the electrical contacts. In instances where the interior portion of the surface has few or no electrical contacts, one or more thermal conductors 1230, or thermal input/outputs (I/Os) may be positioned at the interior portion of the surface of the circuit chip 1204 to conduct heat away from the circuit chip 1204.

The present disclosure is not to be limited in scope by the specific embodiments described herein. Indeed, various modifications of the present disclosure, in addition to those described herein, will be apparent to those of ordinary skill in the art from the foregoing description and accompanying drawings. Thus, such modifications are intended to fall within the scope of the following appended claims. Further, although the present disclosure has been described herein in the context of a particular implementation in a particular environment for a particular purpose, those of ordinary skill in the art will recognize that its usefulness is not limited thereto and that the present disclosure can be beneficially implemented in any number of environments for any number of purposes. Accordingly, the claims set forth below should be construed in view of the full breadth and spirit of the present disclosure as disclosed herein.

## Claims

1. A circuit device comprising:
a circuit chip having a plurality of electrical contacts positioned at a surface of the circuit chip so as to form one or more channels at the surface of the circuit chip, the one or more channels being substantially devoid of electrical contacts such that one or more corresponding channels are formed in a chip carrier for routing electrically conductive traces from one or more of the plurality of electrical contacts on a routing layer of the chip carrier.

2. The circuit device as in Claim 1, further comprising:
a chip carrier having at least one routing layer for routing electrically conductive traces from one or more of the plurality of electrical contacts toward a periphery of the chip carrier, wherein one or more conductive traces are routed via one or more channels in the at least one routing layer substantially corresponding to one or more of the plurality of channels at the surface of the circuit chip.

3. The circuit device as in Claim 2, wherein the one or more channels in the at least one routing layer are substantially devoid of vias.

4. The circuit device as in Claim 1, wherein the plurality of electrical contacts include a plurality of signal contacts and a plurality of power and ground contacts, wherein one or more of the plurality of signal contacts are positioned at a periphery of the surface of the circuit chip and one or more of the plurality of power and ground contacts are positioned at an interior of the surface of the circuit chip.

5. The circuit device as in Claim 4, wherein one or more of the plurality of signal contacts are positioned adjacent to at least one of the one or more channels.

6. The circuit device as in Claim 1, wherein at least one of the one or more channels extend from a periphery of the surface of the circuit chip into an interior of the surface of the circuit chip.

7. A circuit device comprising:
a circuit chip having a plurality of power and ground electrical contacts and a plurality of signal electrical contacts positioned at a surface of the circuit chip;
wherein a substantial portion of the plurality of power and ground electrical contacts are positioned at an interior of the surface of the circuit chip; and
wherein a substantial portion of the plurality of signal electrical contacts are positioned at a periphery of the surface of the circuit chip.

8. The circuit device as in Claim 7, wherein the plurality of power and ground electrical contacts and the plurality of signal electrical contacts are positioned so as to form one or more channels at the surface of the circuit chip, the one or more channels being substantially devoid of electrical contacts such that one or more corresponding channels are formed in a chip carrier for routing electrically conductive traces from one or more of the plurality of electrical contacts on a routing layer of the chip carrier.

9. The circuit device as in Claim 8, further comprising:
a chip carrier having at least one routing layer for routing electrically conductive traces from one or more of the electrical contacts toward a periphery of the chip carrier,
wherein one or more conductive traces are routed via one or more channels in the at least one routing layer substantially corresponding to one or more of the plurality of channels at the surface of the circuit chip.

10. The circuit device as in Claim 8, wherein a substantial portion of the plurality of signal electrical contacts are positioned adjacent to at least one of the one or more channels.

11. A circuit device comprising:
a circuit chip having a plurality of electrical contacts positioned at a surface of the circuit chip;
wherein a peripheral portion of the surface of the circuit chip has a first density of electrical contacts;
wherein an interior portion of the surface of the circuit chip has a second density of electrical contacts; and
wherein the second density is substantially less than the first density.

12. The circuit device as in Claim 11, wherein the circuit chip further comprises at least one thermal transfer contact positioned at the interior portion of the surface of the circuit chip.

13. The circuit device as in Claim 11, wherein the plurality of electrical contacts are positioned so as to form one or more channels at the surface of the circuit chip, the one or more channels being substantially devoid of electrical contacts such that one or more corresponding channels are formed in a chip carrier for routing electrically conductive traces from one or more of the plurality of electrical contacts on a routing layer of the chip carrier.

14. The circuit device as in Claim 13, further comprising:
a chip carrier having at least one routing layer for routing electrically conductive traces from one or more of the plurality of electrical contacts toward a periphery of the chip carrier, wherein one or more conductive traces are routed via one or more channels in the at least one routing layer substantially corresponding to one or more of the plurality of channels at the surface of the circuit chip.

15. A method comprising:
positioning a plurality of electrical contacts at a surface of a circuit chip so as to form one or more channels at the surface of the circuit chip, the one or more channels being substantially clear of electrical contacts; and
forming one or more electrically conductive traces at one or more routing layers of a chip carrier supporting the circuit chip, wherein the one or more electrically conductive traces are routed from one or more of the plurality of electrical contacts toward a periphery of the chip carrier via one or more channels in the at least one routing layer substantially corresponding to one or more of the plurality of channels at the surface of the circuit chip.

16. The method as in Claim 15, wherein the one or more channels in the at least one routing layer of the chip carrier are substantially devoid of vias.

17. The method as in Claim 15, wherein the plurality of electrical contacts include a plurality of signal contacts and a plurality of power and ground contacts, and wherein one or more of the plurality of signal contacts are positioned at a periphery of the surface of the circuit chip and one or more of the plurality of power and ground contacts are positioned at an interior of the surface of the circuit chip.

18. The method as in Claim 17, wherein one or more of the plurality of signal contacts are positioned adjacent to at least one of the one or more channels.
